(19) Europäisches Patentamt
European Patent Office
Office européen des brevets

(11) **EP 2 896 968 B1**

(12) **FASCICULE DE BREVET EUROPEEN**

(45) Date de publication et mention de la délivrance du brevet:
**06.04.2016 Bulletin 2016/14**

(51) Int Cl.:
***G01R 31/08*** *(2006.01)*

(21) Numéro de dépôt: **15150190.5**

(22) Date de dépôt: **06.01.2015**

(54) **Procédé de localisation d'une source d'impulsions dans un milieu dispersif**

Lokalisierungsverfahren einer Impulsquelle in einem dispersivem Medium

Method for locating a source of pulses in a dispersive medium

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.01.2014 FR 1450348**

(43) Date de publication de la demande:
**22.07.2015 Bulletin 2015/30**

(73) Titulaire: **Institut Polytechnique de Grenoble 38000 Grenoble (FR)**

(72) Inventeur: **Ioana, Cornel 38190 Brignoud (FR)**

(74) Mandataire: **Thibon, Laurent Cabinet Beaumont 1, rue Champollion 38000 Grenoble (FR)**

(56) Documents cités:
**WO-A1-2005/073752      DE-A1-102010 013 613**

• **SAMANTARAY S R: "Phase-Space-Based Fault Detection in Distance Relaying", IEEE TRANSACTIONS ON POWER DELIVERY, IEEE SERVICE CENTER, NEW YORK, NY, US, vol. 26, no. 1, 1 janvier 2011 (2011-01-01), pages 33-41, XP011340575, ISSN: 0885-8977, DOI: 10.1109/TPWRD.2010.2058817**
• **FLORIN-MARIAN BIRLEANU ET AL: "A vector approach to transient signal processing", INFORMATION SCIENCE, SIGNAL PROCESSING AND THEIR APPLICATIONS (ISSPA), 2012 11TH INTERNATIONAL CONFERENCE ON, IEEE, 2 juillet 2012 (2012-07-02), pages 1141-1146, XP032241559, DOI: 10.1109/ISSPA.2012.6310462 ISBN: 978-1-4673-0381-1**

**EP 2 896 968 B1**

**Description**

Domaine

La présente demande concerne un procédé de localisation d'une source d'impulsions dans un milieu dispersif.

Exposé de l'art antérieur

Dans les lignes de transport, par exemple d'énergie électrique, d'eau ou d'informations, différents phénomènes peuvent conduire à la génération d'impulsions en un point de ces lignes. On cherche alors à détecter et à localiser la zone source de ces impulsions.

A titre d'exemple, dans un câble électrique, un défaut dans l'isolation du câble peut conduire à l'apparition de décharges électriques parasites, chaque décharge se traduisant par la génération d'une impulsion dont la durée, ou largeur, est généralement inférieure à 1 μs.

La localisation de la source d'impulsions permet de localiser le défaut et donc de remplacer ou de réparer le tronçon de câble affecté par le défaut. Une erreur sur la position exacte de la source d'impulsions peut amener à intervenir sur une mauvaise portion de câble et à devoir répéter l'opération de maintenance.

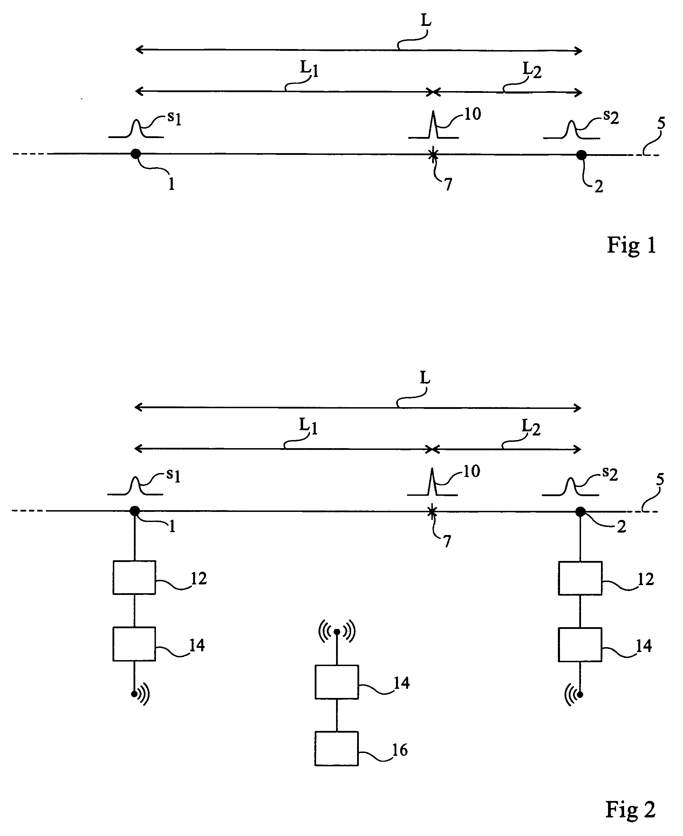

La figure 1 représente schématiquement un dispositif adapté à localiser une source d'impulsions sur une ligne.

Deux capteurs 1 et 2 sont disposés sur un câble électrique 5, de part et d'autre d'une source d'impulsions électriques 7. Chaque capteur est associé à des moyens de communication (non représentés) et à un module de traitement du signal (non représenté).

Une longueur de câble connue, L, sépare le capteur 1 du capteur 2. On cherche à connaître les longueurs de câble, $L_1$ et $L_2$, séparant la source 7 respectivement du capteur 1 et du capteur 2.

Lorsqu'une décharge électrique 10 se produit au niveau de la source 7, des impulsions $s_1$ et $s_2$ se propagent jusqu'aux capteurs 1 et 2. Dans l'exemple représenté, la longueur $L_1$ étant supérieure à la longueur $L_2$, l'impulsion $s_1$ est reçue par le capteur 1 un temps $\Delta t$ après que l'impulsion $s_2$ a été reçue par le capteur 2. L'écart $\Delta t$ est inversement proportionnel à la vitesse de propagation des impulsions dans le câble et proportionnel à la différence entre les longueurs $L_1$ et $L_2$. En mesurant $\Delta t$, en connaissant la vitesse et la longueur de câble L entre les capteurs, on calcule $L_1$ ou $L_2$ et donc la position de la source 7 sur le câble 5.

Pour mesurer $\Delta t$, les capteurs 1 et 2 doivent être synchronisés par l'intermédiaire de systèmes tels que des modules GPS ("Global Positioning System" - système de localisation mondial), des modems radio ou de la fibre optique. Un écart de synchronisation entre les capteurs 1 et 2 entraîne une erreur sur $\Delta t$ et donc sur la position exacte de la source 7. A titre d'exemple, pour une vitesse de propagation v=1,6*10^8 m.s^{-1}, une erreur de 160 ns sur la valeur de $\Delta t$ entraîne une erreur sur la position de la source égale à 25,6 m.

Les documents "IEEE TRANSACTIONS ON POWER DELIVERY, IEEE SERVICE CENTER, NEW YORK, NY, US, vol. 26, no. 1, 1er janvier 2011 (2011-01-01), pages 33-41", DE 10 2010 013613, WO 2005/073752 et "INFORMATION SCIENCE, SIGNAL PROCESSING AND THEIR APPLICATIONS (ISSPA), 2012 11TH INTERNATIONAL CONFERENCE ON, IEEE, 2 juillet 2012 (2012-07-02), pages 1141-1146" décrivent divers systèmes de localisation de défauts.

Résumé

On cherche ici à réduire l'erreur sur la localisation de la source.

Ainsi un mode de réalisation prévoit un procédé de localisation dans un milieu dispersif d'une source d'impulsions par au moins une paire de capteurs, le procédé comprenant les étapes suivantes: au niveau de chaque capteur, détecter une impulsion en provenance de la source ; pour chacune desdites impulsions, construire un diagramme de phase à partir de N vecteurs dont les coordonnées correspondent à l'amplitude de l'impulsion à des instants ti successifs d'échantillonnage ; et pour chaque paire de capteurs, calculer le rapport entre les distances $L_1$ et $L_2$ de chaque capteur à la source par la formule :

$$L_1 \Big/ L_2 \;=\; \sum_{i=1}^{N} \left| \overrightarrow{r_1(t_i)} \right| \Big/ \sum_{i=1}^{N} \left| \overrightarrow{r_2(t_i)} \right|$$

où $|\overrightarrow{r_1(t_i)}|$ et $|\overrightarrow{r_2(t_i)}|$ sont les normes des vecteurs $\overrightarrow{r_1(t_i)}$ et $\overrightarrow{r_2(t_i)}$ des diagrammes de phase correspondant aux impulsions détectées par les capteurs.

Selon un mode de réalisation, le milieu dispersif est un milieu guidé.

Selon un mode de réalisation, la localisation de la source est effectuée par une paire de capteurs, la distance L entre les capteurs étant connue.

Selon un mode de réalisation, le milieu dispersif est un câble électrique.

Selon un mode de réalisation, les coordonnées des vecteurs des diagrammes de phase correspondent à trois instants d'échantillonnage successifs.

Selon un mode de réalisation, la détection d'une impulsion au niveau de chaque capteur comprend les étapes suivantes : le découpage d'un signal reçu par le capteur en portions de même durée ; le filtrage de chaque portion par une pluralité M de filtres passe-bande de fréquences centrales $f_j$ différentes ; le calcul d'un niveau moyen d'énergie associé à chaque fréquence $f_j$ d'une portion ; le calcul d'une distance spectrale $D_{W/W+1}$ entre des première et deuxième portions successives ; et la comparaison de la distance spectrale $D_{W/W+1}$ avec un seuil.

Selon un mode de réalisation, la valeur du seuil est fixée lors d'une étape préalable d'étalonnage.

Selon un mode de réalisation, la distance spectrale $D_{W/W+1}$ est calculée sur la base de la formule suivante :

$$D_{W/W+1} = \sqrt{\left( \sqrt{\sum_{i=1}^{M} \left( X^{w+1}(f_j) \right)^2} - \sqrt{\sum_{i=1}^{M} \left( X^{w}(f_j) \right)^2} \right)^2}$$

où $X^W(f_j)$ et $X^{W+1}(f_j)$ sont les niveaux moyens d'énergie correspondant à la fréquence fj respectivement de la première portion et de la deuxième portion.

Selon un mode de réalisation, la durée d'une portion est comprise entre 5 et 15 $\mu$s.

Selon un mode de réalisation, le pas séparant deux instants successifs d'échantillonnage est compris entre 1 et 50 ns.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, décrite précédemment, représente schématiquement un dispositif adapté à localiser une source d'impulsions électriques sur un câble ;

la figure 2 représente schématiquement un mode de réalisation d'un dispositif de localisation d'une source d'impulsions électriques sur un câble ;

la figure 3 représente l'allure d'impulsions détectées au niveau des capteurs de la figure 2 ;

la figure 4 illustre un mode de détection d'une impulsion par le dispositif de la figure 2 ;

les figures 5A et 5B représentent respectivement une impulsion et un diagramme de phase correspondant à cette impulsion ; et

les figures 6A et 6B sont respectivement des diagrammes de phase de deux impulsions et une projection sur un plan de ces diagrammes.

Par souci de clarté, de mêmes éléments ont été désignés par de mêmes références aux différentes figures.

Description détaillée

Les modes de réalisation décrits en détail ci-après visent la localisation d'une source d'impulsions électriques correspondant à des décharges électriques en un point d'un câble électrique. Plus généralement, le procédé s'applique à la localisation de tout type de source d'impulsions dans tout type de milieu dispersif guidé ou non. Un autre exemple de milieu dispersif guidé est une conduite d'eau. Dans ce cas les impulsions à détecter ne sont pas des impulsions électriques mais des impulsions de surpression. Dans le cas d'un milieu dispersif non guidé, trois capteurs au moins sont utilisés et la position de la source d'impulsions est déterminée par triangulation à partir des rapports de distances entre la source et chacun des capteurs. Un exemple de milieu dispersif non guidé est une pièce mécanique sous contrainte dans laquelle on cherche à localiser des zones de rupture internes, les capteurs sont alors des capteurs de vibration ou des capteurs sonores.

La figure 2 illustre schématiquement un mode de réalisation d'un dispositif de détection d'une source d'impulsions électriques dans un câble électrique.

Le dispositif comprend deux capteurs, 1 et 2, disposés à une distance L l'un de l'autre sur un câble électrique 5, de part et d'autre d'une source d'impulsions électriques 7. Chaque capteur est associé à un module de traitement de signal 12 et à des moyens de communication 14. Le dispositif comprend en outre un module de calcul 16 associé à des moyens de communication 14. Le module de calcul 16 reçoit des informations en provenance des capteurs. Les moyens de communication 14 peuvent être des moyens sans fil ou filaires, par exemple une connexion par fibre optique ou par courant porteur de ligne.

On cherche à connaître les longueurs de câble, $L_1$ et $L_2$, séparant la source 7 des capteurs 1 et 2. Lorsqu'une décharge électrique 10 se produit au niveau de la source 7, des impulsions $s_1$ et $s_2$, initialement identiques, se propagent respectivement jusqu'au capteur 1 et jusqu'au capteur 2.

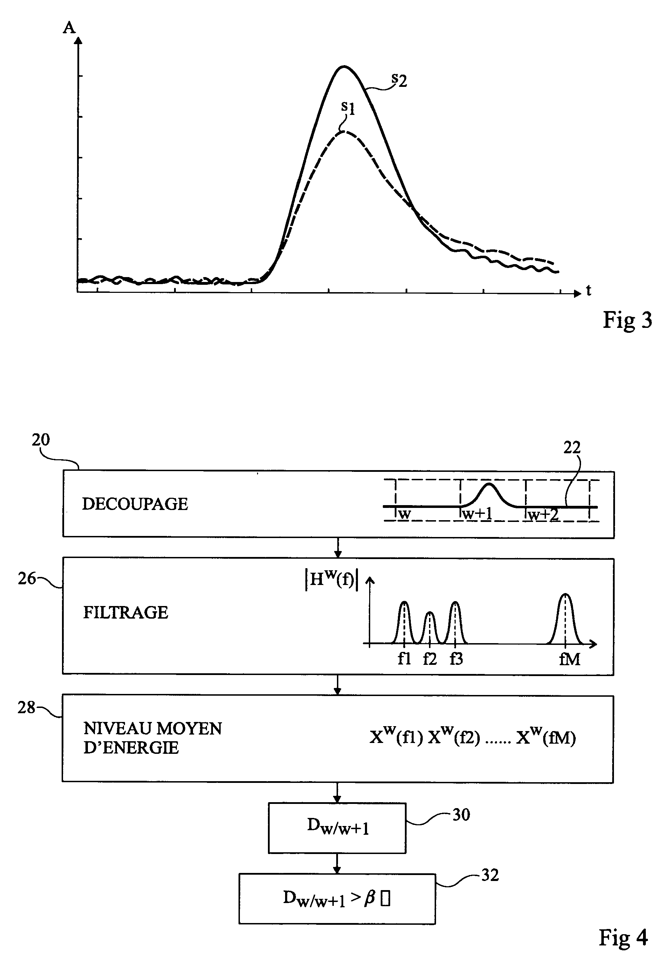

La figure 3 représente l'allure des impulsions $s_1$ et $s_2$ mises en regard l'une de l'autre. L'impulsion $s_1$ est plus atténuée et plus déformée que l'impulsion $s_2$. Ceci est la conséquence du fait que la distance $L_1$ de propagation de l'impulsion $s_1$ est supérieure à la distance $L_2$ de propagation de l'impulsion $s_2$ et du fait que le câble 5 est un milieu dispersif.

On prévoit ici de déterminer les distances $L_1$ et $L_2$ à partir de la différence de forme des impulsions $s_1$ et $s_2$ plutôt qu'à partir de la différence de temps de propagation entre ces impulsions. Ainsi, il n'est pas nécessaire de synchroniser entre eux les capteurs 1 et 2 de la figure 2. Il n'est donc pas nécessaire d'associer à ces capteurs des moyens coûteux ou complexes de synchronisation comme cela a été décrit en relation avec la figure 1.

L'inventeur a montré que le rapport entre les longueurs $L_1$ et $L_2$ est égal au rapport entre la somme des normes des vecteurs d'un diagramme de phase de l'impulsion $s_1$ et la somme des normes des vecteurs d'un diagramme de phase de l'impulsion $s_2$.

On propose donc ici de détecter les impulsions $s_1$ et $s_2$ puis de construire leur diagramme de phase et de calculer le rapport susmentionné.

La figure 4 illustre schématiquement un exemple de procédé de détection d'un signal transitoire.

A une étape 20, un signal 22 reçu par les capteurs 1 ou 2 est découpé en portions (... W, W+1, W+2, ...) de même durée. A titre d'exemple, pour détecter une impulsion dont la largeur est inférieure ou égale à 1 $\mu$s, la durée d'une portion est comprise entre 5 et 25 $\mu$s, par exemple 15 $\mu$s.

A une étape 26, un filtrage est appliqué à chaque portion W par un ensemble de M filtres passe-bande ayant chacun une fréquence centrale $f_j$ différente, j étant compris entre 1 et M.

A une étape 28, un niveau moyen $X^W(f_j)$ est calculé pour chaque fréquence $f_j$ de chaque portion W. Ce niveau moyen d'énergie peut être obtenu en associant un circuit intégrateur à chacun des M filtres.

A une étape 30, pour tout couple de portions successives W et W+1, une distance spectrale $D_{W/W+1}$ est calculée sur la base de la formule suivante :

$$D_{W/W+1} = \sqrt{\left(\sqrt{\sum_{i=1}^{M}\left(X^{W+1}(f_j)\right)^2} - \sqrt{\sum_{i=1}^{M}\left(X^{W}(f_j)\right)^2}\right)^2}$$

A une étape 32, la distance spectrale $D_{W/W+1}$ est comparée à un seuil $\beta$ fixé lors d'une étape préalable d'étalonnage. On déduit de ce que $D_{W/W+1}$ devient supérieur à $\beta$ que la portion W+1 contient un signal autre que du bruit (une impulsion).

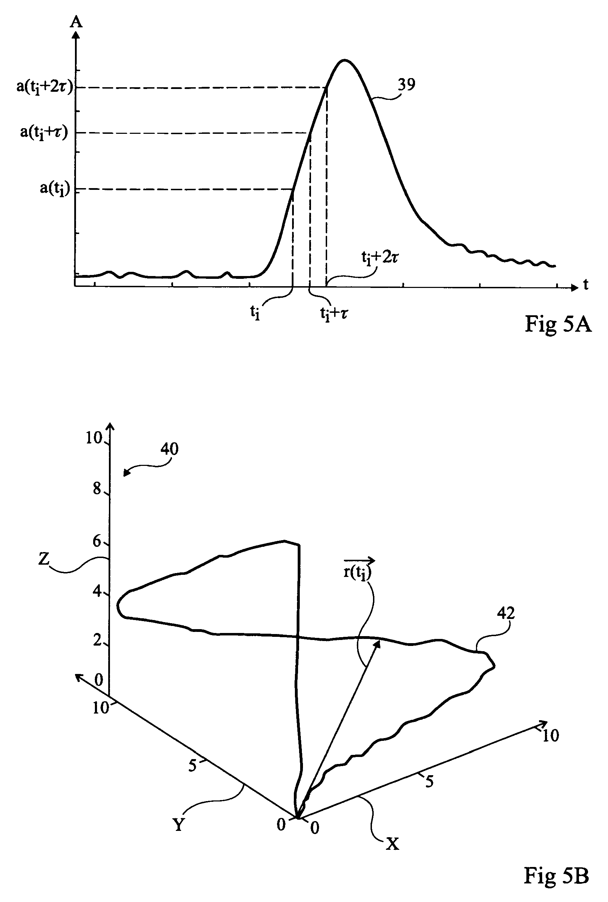

Les figures 5A et 5B illustrent la construction d'un diagramme de phase (représenté en figure 5B) à partir de l'amplitude d'une impulsion (représentée en figure 5A). La construction d'un diagramme de phase à partir d'un signal est présentée au chapitre 3, pages 30 à 46, de la seconde édition du livre "Non-linear Time Series Analysis" de Holger Kantz et Thomas Schreiber publié en 2004 par Cambridge University Press.

La figure 5A représente l'amplitude A d'une impulsion 39 en fonction du temps t. L'impulsion 39 est régulièrement échantillonnée à un pas $\tau$ à des instants successifs ti auxquels correspondent des amplitudes $a(t_i)$.

La figure 5B représente un repère orthonormé 40 d'axes X, Y et Z. A partir de la figure 5A, un vecteur $\overrightarrow{r(t_i)}$ peut être associé à chaque instant d'échantillonnage ti tel que les coordonnées du vecteur $\overrightarrow{r(t_i)}$ selon les trois axes X, Y et Z correspondent à $a(ti)$, $a(t_i+\tau)$ et $a(t_i+2\tau)$, c'est-à-dire aux amplitudes de l'impulsion 39 aux instants d'échantillonnage ti, $t_i+\tau$ et $t_i+2\tau$. L'ensemble des vecteurs $\overrightarrow{r(t_i)}$ constitue, dans le repère 40, le diagramme de phase 42 de l'impulsion 39. A titre d'exemple pour déterminer un diagramme de phase d'une impulsion de largeur inférieure ou égale à 1 $\mu$s, le pas d'échantillonnage $\tau$ est compris entre 1 et 50 ns, par exemple 20 ns (soit une fréquence d'échantillonnage de 50 MHz).

Dans l'exemple décrit, les vecteurs $\overrightarrow{r(t_i)}$ ont trois dimensions. De manière générale, les vecteurs $\overrightarrow{r(t_i)}$ peuvent être associés à un nombre D d'instants d'échantillonnage dans un repère à D dimensions, $D \geq 2$.

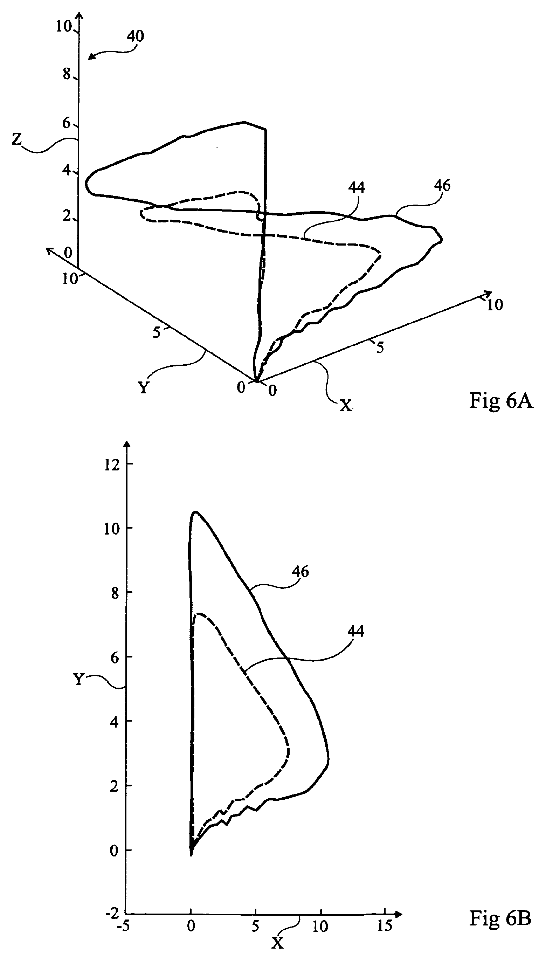

La figure 6A représente deux diagrammes de phase 44 et 46 respectivement associés aux impulsions $s_1$ et $s_2$. Le diagramme de phase 44 est constitué des N vecteurs $\overrightarrow{r_1(t_i)}$ déterminés à partir de l'impulsion $s_1$. Le diagramme de phase 46 est constitué des N vecteurs $\overrightarrow{r_2(t_i)}$ déterminés à partir de l'impulsion $s_2$. Le diagramme de phase 46 est sensiblement un agrandissement du diagramme de phase 44.

En figure 6B, les diagrammes de phase 44 et 46 ont été projetés sur le plan XY de la figure 6A pour faire ressortir de manière plus apparente que le diagramme de phase 46 est sensiblement un agrandissement du diagramme de phase 44.

Comme cela a été indiqué précédemment, le rapport entre les distances $L_1$ et $L_2$ est égal au rapport entre la somme des normes des vecteurs d'un diagramme de phase de l'impulsion $s_1$ et la somme des normes des vecteurs d'un diagramme de phase de l'impulsion $s_2$. En d'autres termes :

$$L_1 / L_2 \;=\; \sum_{i=1}^{N} \left| \overrightarrow{r_1(t_i)} \right| \Big/ \sum_{i=1}^{N} \left| \overrightarrow{r_2(t_i)} \right|$$

où $|\overrightarrow{r_1(t_i)}|$ et $|\overrightarrow{r_2(t_i)}|$ sont les normes des vecteurs $\overrightarrow{r_1(t_i)}$ et $\overrightarrow{r_2(t_i)}$.

Des tests en laboratoire ont été effectués par l'inventeur et montrent qu'un tel procédé permet de localiser une source d'impulsions avec une meilleure précision que dans le cas d'un procédé basé sur des différences d'instants d'arrivée d'impulsions au niveau de capteurs. A titre d'exemple, lorsque les capteurs sont disposés sur un câble coaxial, à 300 m l'un de l'autre, la position d'une source d'impulsions est déterminée avec une erreur de 1,024 m seulement, et non pas 25,6 m comme dans le cas de la figure 1.

Des modes de réalisation particuliers ont été décrits. Diverses variantes et modifications apparaîtront à l'homme de l'art. En particulier, bien qu'un mode de réalisation ait été décrit dans le cas d'impulsions électriques se propageant dans un câble électrique, on rappellera que le procédé s'applique à tout type de milieu dispersif guidé ou non et à différentes natures de signal. Dans le cas d'un milieu dispersif non guidé, les diagrammes de phase d'impulsions détectées au niveau d'au moins trois capteurs permettent de calculer des rapports de distance entre la source et chacune des paires de capteurs. La position exacte de la source est alors déduite à partir de ces rapports par triangulation.

De plus, le procédé a été décrit dans le cas où des capteurs sont situés de part et d'autre d'une source d'impulsions. Ils pourraient aussi être disposés du même côté d'une source.

## Revendications

1. Procédé de localisation dans un milieu dispersif (5) d'une source (7) d'impulsions ($s_1$, $s_2$) par au moins une paire de capteurs (1, 2), le procédé comprenant les étapes suivantes :

    au niveau de chaque capteur (1, 2), détecter une impulsion (s1, s2) en provenance de la source (7) ;
    pour chacune desdites impulsions, construire un diagramme de phase (44, 46) à partir de N vecteurs dont les coordonnées correspondent à l'amplitude de l'impulsion ($s_1$, $s_2$) à un instant d'échantillonnage ti et à des instants successifs suivants d'échantillonnage ($t_i+\tau$, $t_i+2\tau$); et
    pour chaque paire de capteurs, calculer le rapport entre les distances $L_1$ et $L_2$ de chaque capteur à la source par la formule :

$$L_1 \Big/ L_2 \;=\; \sum_{i=1}^{N} \left| \overrightarrow{r_1(t_i)} \right| \Big/ \sum_{i=1}^{N} \left| \overrightarrow{r_2(t_i)} \right|$$

où $|\overrightarrow{r_1(t_i)}|$ et $|\overrightarrow{r_2(t_i)}|$ sont les normes des vecteurs $\overrightarrow{r_1(t_i)}$ et $\overrightarrow{r_2(t_i)}$ des diagrammes de phase (44, 46) correspondant aux impulsions détectées par les capteurs (1, 2).

2. Procédé selon la revendication 1, dans lequel le milieu dispersif (5) est un milieu guidé.

3. Procédé selon la revendication 2, dans lequel la localisation de la source (7) est effectuée par une paire de capteurs (1, 2), la distance L entre les capteurs étant connue.

4. Procédé selon la revendication 2 ou 3, dans lequel le milieu dispersif (5) est un câble électrique.

5. Procédé selon l'une quelconque des revendications 1 à 4, dans lequel les coordonnées des vecteurs des diagrammes de phase (44, 46) correspondent à trois instants d'échantillonnage successifs (ti, $t_i+\tau$, $t_i+2\tau$).

6. Procédé selon l'une quelconque des revendications 1 à 5, dans lequel la détection d'une impulsion ($s_1$, $s_2$) au niveau de chaque capteur (1, 2) comprend les étapes suivantes :

le découpage (20) d'un signal (22) reçu par le capteur (1, 2) en portions de même durée ;

le filtrage (26) de chaque portion par une pluralité M de filtres passe-bande de fréquences centrales $f_j$ différentes ;

le calcul (28) d'un niveau moyen d'énergie associé à chaque fréquence $f_j$ d'une portion ;

le calcul (30) d'une distance spectrale $D_{W/W+1}$ entre des première (W) et deuxième (W+1) portions successives ; et

la comparaison de la distance spectrale $D_{W/W+1}$ avec un seuil ($\beta$).

7. Procédé selon la revendication 6, dans lequel la valeur du seuil ($\beta$) est fixée lors d'une étape préalable d'étalonnage.

8. Procédé selon la revendication 6 ou 7, dans lequel la distance spectrale $D_{W/W+1}$ est calculée sur la base de la formule suivante :

$$D_{W/W+1} = \sqrt{\left(\sqrt{\sum_{i=1}^{M}\left(X^{w+1}(f_j)\right)^2} - \sqrt{\sum_{i=1}^{M}\left(X^{w}(f_j)\right)^2}\right)^2}$$

où $x^W(f_j)$ et $x^{W+1}(f_j)$ sont les niveaux moyens d'énergie correspondant à la fréquence $f_j$ respectivement de la première portion (W) et de la deuxième portion (W+1).

9. Procédé selon l'une quelconque des revendications 6 à 8, dans lequel la durée d'une portion est comprise entre 5 et 15 μs.

10. Procédé selon l'une quelconque des revendications 1 à 9, dans lequel le pas ($\tau$) séparant deux instants successifs ($t_i$, $t_i+\tau$) d'échantillonnage est compris entre 1 et 50 ns.

**Patentansprüche**

1. Ein Verfahren zum Lokalisieren einer Quelle (7) vom Impulsen ($s_1$, $s_2$) in einem dispersiven Medium (5) mit wenigsten einem Paar von Sensoren (1, 2), wobei das Verfahren die folgenden Schritte aufweist:

auf dem Niveau jedes Sensors (1, 2) detektieren eines Impulses ($s_1$, $s_2$), der von der Quelle (7) stammt;

für jeden der Impulse konstruieren eines Phasendiagramms (44, 46) aus N-Vektoren deren Koordinaten der Amplitude des Impulses ($s_1$, $s_2$) zu einem Abtastzeitpunkt $t_i$ und an den nächsten aufeinanderfolgenden Abtastzeitpunkten ($t_i+\tau$, $t_i+2\tau$) entspricht; und

für jedes Paar von Sensoren berechnen des Verhältnisses zwischen den Abständen $L_1$ und $L_2$ von jedem Sensor zur Quelle mit der Formel:

$$L_1 \Big/ L_2 = \sum_{i=1}^{N}\left|\overrightarrow{r_1(t_i)}\right| \Big/ \sum_{i=1}^{N}\left|\overrightarrow{r_2(t_i)}\right|$$

wobei $|\overrightarrow{r_1(t_i)}|$ und $|\overrightarrow{r_2(t_i)}|$ die Normal der Vektoren $\overrightarrow{r_1(t_i)}$ und $\overrightarrow{r_2(t_i)}$ des Phasendiagramms (44, 46) sind und, welche den Impulsen entsprechen, die durch die Sensoren (1, 2) detektiert wurden.

2. Verfahren nach Anspruch 1, wobei das dispersive Medium (5) ein geführtes Medium ist.

3. Verfahren nach Anspruch 2, wobei die Quelle (7) durch ein Paar von Sensoren (1, 2) lokalisiert wird, wobei der Abstand L zwischen den Sensoren bekannt ist.

4. Verfahren nach Anspruch 2 oder 3, wobei das dispersive Medium (5) ein elektrisches Kabel ist.

5. Verfahren nach einem der Ansprüche 1 bis 4, wobei die Koordinaten der Vektoren des Phasendiagramms (44, 46) drei aufeinanderfolgenden Abtastzeitpunkten ($t_i$, $t_i+\tau$, $t_i+2\tau$) entsprechen.

6. Verfahren nach einem der Ansprüche 1 bis 5, wobei die Detektierung eines Impulses ($S_1$, $S_2$) auf einem Niveau

jedes Sensors (1, 2) die folgenden Schritte aufweist:

Aufteilen (20) eines Signals (22) das durch den Sensor (1, 2) empfangen wurde in Abschnitte mit gleicher Dauer;
Filtern (26) jedes Abschnitts mit einer Vielzahl (M) von Bandpassfiltern mit unterschiedlichen Mittelfrequenzen $f_j$;
Berechnen (28) eines durchschnittlichen Energieniveaus, das mit jeder Frequenz $f_j$ eines Abschnitts assoziiert ist;
Berechnen (30) eines Spektralabstandes $D_{W/W+1}$ zwischen einem ersten (W) und einem zweiten (W + 1) aufeinanderfolgenden Abschnitten;
Vergleichen des Spektralabstandes $D_{W/W+1}$ mit einem Schwellenwert ($\beta$).

7. Verfahren nach Anspruch 6, wobei der Wert des Schwellenwerts ($\beta$) während eines vorhergehenden Abtastzustands eingestellt wurde.

8. Verfahren nach Anspruch 6 oder 7, wobei der Spektralabstand $D_{W/W+1}$ berechnet wird basierend auf der folgenden Formel:

$$D_{W/W+1} = \sqrt{\left( \sqrt{\sum_{i=1}^{M} \left( X^{w+1}(f_j) \right)^2} - \sqrt{\sum_{i=1}^{M} \left( X^{w}(f_j) \right)^2} \right)^2}$$

wobei $X^W(f_j)$ und $X^{W+1}(f_j)$ die durchschnittlichen Energieniveaus sind, die jeweils der Frequenz des ersten Teils (W) und des zweiten Teils (W+1) entsprechen.

9. Verfahren nach einem der Ansprüche 6 bis 8, wobei die Zeitdauer eines Abschnitts im Bereich von 5 bis 15 $\mu$s liegt.

10. Verfahren nach einem der Ansprüche 1 bis 9, wobei der Schritt ($\tau$) des Aufteilens von zwei aufeinanderfolgenden Abtastzeiten ($t_i$, $t_i+\tau$) im Bereich von 1 bis 50 ns liegt.

**Claims**

1. A method of locating in a dispersive medium (5) a source (7) of pulses ($s_1$, $s_2$) with at least a pair of sensors (1, 2), the method comprising the steps of:

at the level of each sensor (1, 2), detecting a pulse (s1, s2) originating from the source (7);
for each of said pulses, constructing a phase diagram (44, 46) from N vectors having their coordinates corresponding to the amplitude of the pulse ($s_1$, $s_2$) at a sampling time ti and at next successive sampling times (ti+r, $t_i+2\tau$); and
for each pair of sensors, calculating the ratio between distances $L_1$ and $L_2$ from each sensor to the source with formula:

$$L_1 / L_2 = \sum_{i=1}^{N} \left| \overrightarrow{r_1(t_i)} \right| / \sum_{i=1}^{N} \left| \overrightarrow{r_2(t_i)} \right|$$

where $|\overrightarrow{r_1(t_i)}|$ and $|\overrightarrow{r_2(t_i)}|$ are the norms of vectors $\overrightarrow{r_1(t_i)}$ and $\overrightarrow{r_2(t_i)}$ of the phase diagrams (44, 46) corresponding to the pulses detected by the sensors (1, 2).

2. The method of claim 1, wherein the dispersive medium (5) is a guided medium.

3. The method of claim 2, wherein the source (7) is located by a pair of sensors (1, 2), distance L between sensors being known.

4. The method of claim 2 or 3, wherein the dispersive medium (5) is an electric cable.

5. The method of any of claims 1 to 4, wherein the coordinates of the vectors of the phase diagrams (44, 46) correspond to three successive sampling times ($t_i$, $t_i + \tau$, $t_i + 2\tau$).

6. The method of any of claims 1 to 5, wherein the detection of a pulse ($s_1$, $s_2$) at the level of each sensor (1, 2) comprises the steps of:

dividing (20) a signal (22) received by the sensor (1, 2) into portions of same duration;
filtering (26) each portion with a plurality M of bandpass filters having different central frequencies $f_j$;
calculating (28) an average energy level associated with each frequency $f_j$ of a portion;
calculating (30) a spectral distance $D_{W/W+1}$ between a first (W) and a second (W+1) successive portions; and
comparing spectral distance $D_{W/W+1}$ with a threshold ($\beta$).

7. The method of claim 6, wherein the value of the threshold ($\beta$) is set during a previous sampling state.

8. The method of claim 6 or 7, wherein spectral distance $D_{W/W+1}$ is calculated based on the following formula:

$$D_{W/W+1} = \sqrt{\left(\sqrt{\sum_{i=1}^{M}\left(X^{W+1}(f_j)\right)^2} - \sqrt{\sum_{i=1}^{M}\left(X^{W}(f_j)\right)^2}\right)^2}$$

where $X^W(f_j)$ and $X^{W+1}(f_j)$ are the average energy levels corresponding to frequency $f_j$ respectively of the first portion (W) and of the second portion (W+1).

9. The method of any of claims 6 to 8, wherein the duration of a portion is in the range from 5 to 15 $\mu$s.

10. The method of any of claims 1 to 9, wherein the step (r) separating two successive sampling times ($t_i$, ti+r) is in the range from 1 to 50 ns.

Fig 1

Fig 2

A

s2

s1

t

Fig 3

20

DECOUPAGE

22

w   w+1   w+2

26

FILTRAGE

$|H^W(f)|$

f1  f2  f3        fM

28

NIVEAU MOYEN
D'ENERGIE

$X^W(f1)\ X^W(f2)\ ......\ X^W(fM)$

$D_{w/w+1}$

30

$D_{w/w+1} > \beta$

32

Fig 4

Fig 5A

Fig 5B

Fig 6A

Fig 6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 102010013613

- WO 2005073752 A

**Littérature non-brevet citée dans la description**

- IEEE TRANSACTIONS ON POWER DELIVERY. IEEE SERVICE CENTER, 01 Janvier 2011, vol. 26, 33-41
- INFORMATION SCIENCE, SIGNAL PROCESSING AND THEIR APPLICATIONS (ISSPA). *2012 11TH INTERNATIONAL CONFERENCE ON, IEEE,* 02 Juillet 2012, 1141-1146

- **HOLGER KANTZ ; THOMAS SCHREIBER.** Non-linear Time Series Analysis. Cambridge University Press, 2004, 30-46